# EUROPEAN PATENT APPLICATION

(11) **EP 4 589 573 A1**
(43) Date of publication of application: **23.07.2025**
(21) Application number: 23864238.3
(22) Date of filing: 31.01.2023
(51) Int. Cl.: G09F 9/30

(54) **FOLDABLE SUPPORT STRUCTURAL MEMBER AND DISPLAY APPARATUS**

(30) Priority: 14.09.2022 CN 202211117508
(71) Applicant: Hefei Visionox Technology Co., Ltd., Hefei, Anhui 230000 (CN); Kunshan Go-Visionox Opto-Electronics Co., Ltd., Kunshan, Jiangsu 215300 (CN)
(72) Inventor: YU, Qiang, Hefei, Anhui 230000 (CN); QIAO, Guizhou, Hefei, Anhui 230000 (CN); ZHANG, Fang, Hefei, Anhui 230000 (CN); LIN, Chang, Hefei, Anhui 230000 (CN); ZHU, Xiujian, Hefei, Anhui 230000 (CN)
(74) Representative: Kraus & Lederer PartGmbB
(86) International application number: PCT/CN2023/073981
(87) International publication number: WO 2024/055495

(57) **Abstract**

A foldable support structural member and a display device are provided by the present application. The foldable support structural member has an unfolded state and a folded state. The foldable support structural member includes at least two platform carrying parts, a support part and a connecting part. Two adjacent platform carrying parts are movably connected with each other through the support part and the connecting part. The connecting part connects the support part with one of the platform carrying parts, and the connecting part is movably connected to at least one of the platform carrying part and the support part. In a process from the unfolded state to the folded state, the two adjacent platform carrying parts move relative to each other, and the connecting part moves with the platform carrying parts and drives the support part to be pressed and connected onto a bending portion of the flexible display panel. By pressing and connecting the support part onto the bending portion of the flexible display panel, a bending radius of the flexible display panel can increase, creases of the flexible display panel caused by being bent can be reduced, and the display effect and the user visual experience of the flexible display panel can be improved.

## Description

### CROSS REFERENCE TO RELATED APPLICATION

This application claims priority to Chinese Patent Application No. 202211117508.0, titled "FOLDABLE SUPPORT STRUCTURAL MEMBER AND DISPLAY DEVICE" and filed on September 14, 2022, which is hereby incorporated by references in its entirety.

### TECHNICAL FIELD

The present application relates to the technical field of electronic product, and in particular to a foldable support structural member and a display device.

### BACKGROUND

Currently, with the development of display technology, a portable terminal such as a mobile phone, a laptop or the like has become extremely popular. However, as the size of the display terminal product increases, the terminal device has become less portable. With the rapid development of the flexible screen technology, the forms of display devices become increasingly diverse. Among them, the display device with the foldable performance becomes an important development direction in the current display field due to its portability and display diversity.

However, due to the limitation of the structural material of a flexible display panel or a foldable support structural member, after folded many times, obvious concave-and-convex marks may appear in a folding region, which may affect the experience of user.

Therefore, there is an urgent need for a new foldable support structural member and a new display device.

### SUMMARY

The present application provides a foldable support structural member and a display device. By pressing and connecting a support part onto a bending portion of a flexible display panel, a bending radius of the flexible display panel can increase, creases of the flexible display panel caused by being bent can be reduced, and the display effect and the user visual experience of the flexible display panel can be improved.

In a first aspect, embodiments in the present application provide a foldable support structural member for supporting a flexible display panel. The foldable support structural member has an unfolded state and a folded state, and includes at least two platform carrying parts, a support part and a connecting part. Two adjacent platform carrying parts are movably connected with each other through the support part and the connecting part. The connecting part connects the support part with one of the platform carrying parts. The connecting part is movably connected to at least one of the platform carrying part and the support part. In a process from the unfolded state to the folded state, the two adjacent platform carrying parts move relative to each other, and the connecting part moves with the platform carrying parts and drives the support part to be pressed and connected onto a bending portion of the flexible display panel.

In a second aspect, embodiments in the present application provide a display device including a flexible display panel and the foldable support structural member according to the embodiments as described above. The foldable support structural member is arranged on a backlight side of the flexible display panel.

Compared with a related art, the foldable support structural member provided by the embodiments of the present application includes at least two platform carrying parts, the support part and the connecting part. The platform carrying parts and the support part can support the flexible display panel in both the unfolded state and the folded state. In a process from the unfolded state to the folded state, two adjacent platform carrying parts move relative to each other to drive the flexible display panel to be correspondingly bent. In the embodiments of the present application, by moving the connecting part with the platform carrying parts and driving the support part to be pressed and connected onto the bending portion of the flexible display panel, that is, by exerting the pressure onto the bending portion of the flexible display panel through the support part, the bending portion of the flexible display panel is bent and deformed in a direction away from the support part, thereby increasing a bending radius of the bending portion of the flexible display panel. Due to the relatively large bending radius, the time of forming the cracks and the bending marks caused by the bending portion of the flexible display panel being bent for a long term can be delay, the creases caused by the flexible display panel being bent can be reduced, the service life of the flexible display panel can increase, the using stability of the flexible display panel can be improved, and the display effect and the user visual experience of the flexible display panel can be improved.

### BRIEF DESCRIPTION OF THE DRAWINGS

Fig. 1 shows a structural schematic view of a foldable support structural member according to an embodiment of the present application;
Fig. 2 shows a structural view of a film layer at line A-A in Fig. 1 according to an embodiment of the present application;
Fig. 3 shows a structural schematic view of a foldable support structural member in a folded state according to an embodiment of the present application;
Fig. 4 shows a structural schematic view of a foldable support structural member in a folding process according to an embodiment of the present application;
Fig. 5 shows a structural schematic view of a foldable support structural member in a process from a folded state to a folded state according to an embodiment of the present application;
Fig. 6 shows a local enlarged view at region C in Fig. 5 according to an embodiment of the present application;
Fig. 7 shows a structural schematic view of a platform carrying part according to an embodiment of the present application;
Fig. 8 shows a schematic view of a connection between a support part and a connecting part according to an embodiment of the present application;
Fig. 9 shows a schematic view of a connection between a support part and a connecting part according to another embodiment of the present application;
Fig. 10 shows a structural view of a film layer at line A-A in Fig. 1 according to another embodiment of the present application;
Fig. 11 shows a structural schematic view of a foldable support structural member according to another embodiment of the present application;
Fig. 12 shows a structural view of a film layer at line B-B in Fig. 1 according to an embodiment of the present application;
Fig. 13 shows a structural schematic view of a foldable support structural member in a folded state according to another embodiment of the present application;
Fig. 14 shows a structural view of a film layer at line B-B in Fig. 1 according to another embodiment of the present application;
Fig. 15 shows a structural schematic view of a foldable support structural member in a folded state according to another embodiment of the present application;
Fig. 16 shows a structural schematic view of a foldable support structural member in a folding process according to another embodiment of the present application;
Fig. 17 shows a structural schematic view of a support part according to an embodiment of the present application;
Fig. 18 shows a structural schematic view of a support part according to another embodiment of the present application;
Fig. 19 shows a structural schematic view of a support part according to another embodiment of the present application;
Fig. 20 shows a structural schematic view of a support part according to another embodiment of the present application;
Fig. 21 shows a structural schematic view of a support part according to another embodiment of the present application;
Fig. 22 shows a structural schematic view of a support part according to another embodiment of the present application;
Fig. 23 shows a structural schematic view of a support part according to another embodiment of the present application; and
Fig. 24 shows a structural schematic view of a support part according to another embodiment of the present application.

### DETAILED DESCRIPTION

Features and exemplary embodiments in various aspects of the present application will be described in detail below. In order to make the objects, technical solutions and advantages of the present application clearer, the present application will be further described in detail below in conjunction with the drawings and the specific embodiments. It should be understood that the specific embodiments described here are only configured to explain the present application, not to confine the present application. It is apparent to one skilled in the art that the present application can be practiced without some of these specific details. The description of the embodiments below is only to provide a better understanding of the present application by showing examples of the present application.

Various modifications and changes of the embodiments, which are obvious to those skilled in the art, can be made in the present application without departing from the gist or scope of the present application. Therefore, the present application aims to cover the modifications and changes of the present application that fall within the scope of the corresponding claims (technical solutions to be protected) and their equivalents. It should be noted that the embodiments provided by the present application can be combined with one another without contradiction.

In a related art, when a flexible display panel is in a folded state, the smaller the bending radius of the flexible display panel is, the larger the deformation of a film layer at a bending portion of the flexible display panel is. There is a confine on the number of bending times at the bending portion of the flexible display panel. When the number of bending times exceeds the confine, the cracks or bending marks will appear at the bending portion of the flexible display panel due to bending fatigue. In each folding process, when the bending radius at the bending portion of the flexible display panel is relatively small resulting in increasing the deformation of the film layer, the process of forming the cracks or bending marks on the film layer will be further accelerated, reduce the number of bending times at the bending portion of the flexible display panel will be reduced, and thus the service life of the flexible display panel will decrease.

In order to improve the above problems, the embodiments of the present application provide a foldable support structural member. By pressing and connecting a support part onto a bending portion of a flexible display panel, a bending radius of the flexible display panel can increase, creases of the flexible display panel caused by being bent can be reduced, and the display effect and the user visual experience of the flexible display panel can be improved.

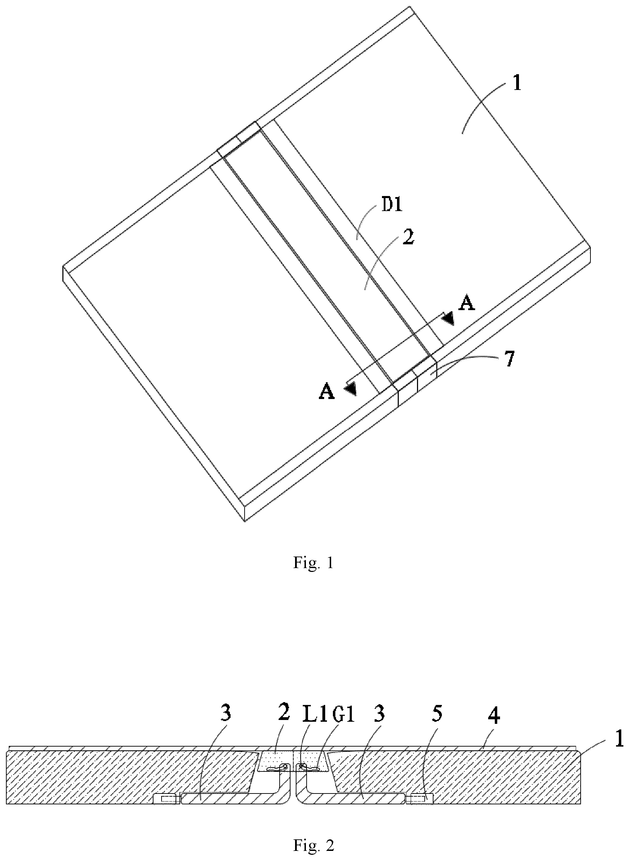

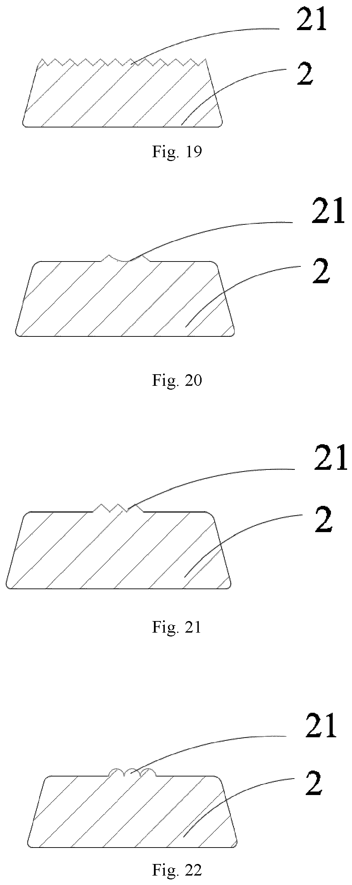

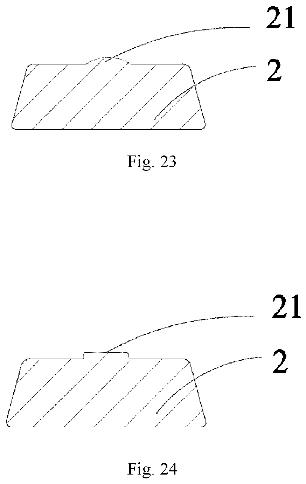

The detailed explanation of embodiments of the foldable support structural member and a display device will be provided below referring to Fig. 1 to Fig. 24 of the drawings.

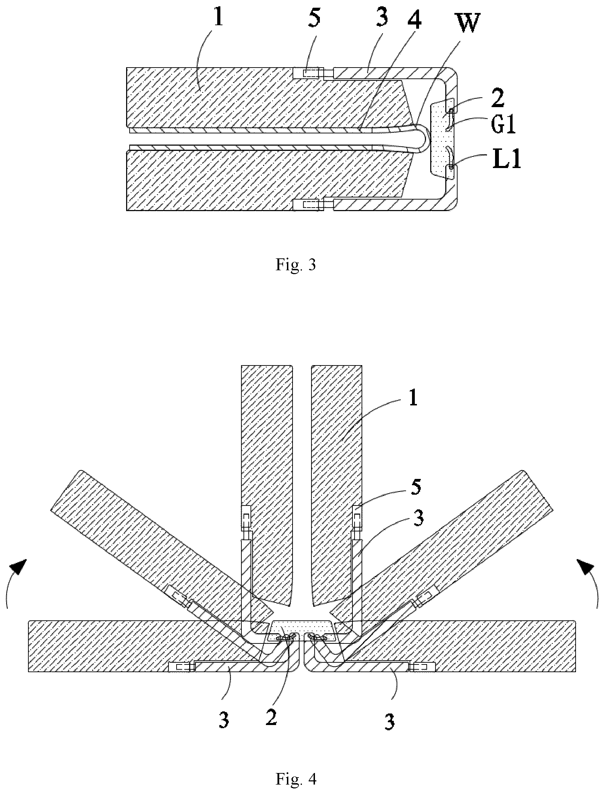

Referring to Fig. 1 to Fig. 3, Fig. 1 shows a structural schematic view of a foldable support structural member according to an embodiment of the present application; Fig. 2 shows a structural view of a film layer at line A-A in Fig. 1 according to an embodiment of the present application; and Fig. 3 shows a structural schematic view of a foldable support structural member in a folded state according to an embodiment of the present application

The embodiments of the present application provide the foldable support structural member for supporting a flexible display panel. The foldable support structural member has an unfolded state and a folded state, and includes at least two platform carrying parts 1, a support part 2 and a connecting part 3. Two adjacent platform carrying parts 1 are movably connected with each other through the support part 2 and the connecting part 3. The connecting part 3 connects the support part 2 with one of the platform carrying parts 1. The connecting part 3 is movably connected to at least one of the platform carrying part 1 and the support part 2. In a process from the unfolded state to the folded state, the two adjacent platform carrying parts 1 move relative to each other, and the connecting part 3 moves with the platform carrying parts 1 and drives the support part 2 to be pressed and connected onto a bending portion W of the flexible display panel 4.

The foldable support structural member provided by the embodiments of the present application includes at least two platform carrying parts 1, the support part 2 and the connecting part 3. The platform carrying parts 1 and the support part 2 can support the flexible display panel 4 in both the unfolded state and the folded state. In a process from the unfolded state to the folded state, two adjacent platform carrying parts 1 move relative to each other to drive the flexible display panel 4 to be correspondingly bent. In the embodiments of the present application, by moving the connecting part 3 with the platform carrying parts 1 and driving the support part 2 to be pressed and connected onto the bending portion W of the flexible display panel 4, that is, by exerting the pressure onto the bending portion W of the flexible display panel 4 through the support part 2, the bending portion W of the flexible display panel 4 is bent and deformed in a direction away from the support part 2, thereby increasing a bending radius of the bending portion W of the flexible display panel 4. Due to the relatively large bending radius, the time of forming the cracks and the bending marks caused by the bending portion W of the flexible display panel 4 being bent for a long term can be delay, the creases caused by the flexible display panel 4 being bent can be reduced, the service life of the flexible display panel 4 can increase, the using stability of the flexible display panel 4 can be improved, and the display effect and the user visual experience of the flexible display panel 4 can be improved.

Furthermore, since the foldable support structural member in the embodiment merely includes three kinds of components: the platform carrying parts 1, the support part 2 and connecting part 3, compared with the complex structure formed by numerous gears, hinges and other components in a related art, the foldable support structural member in the embodiment has a simple structure, is easy to be produced and assembled, and has the high reliability.

In this embodiment, when the foldable support structural member is in the unfolded state, surfaces of the platform carrying parts 1 and the support part 2 facing the flexible display panel 4 can be in the same plane to achieve the flat support for the flexible display panel 4. Optionally, the platform carrying parts 1 and the flexible display panel 4 can be connected through an adhesive layer, so as to further improve the connection stability between the platform carrying parts 1 and the flexible display panel 4.

It should be noted that there may be only one connecting part 3 between the two adjacent platform carrying parts 1, that is, the connecting part 3 can be connected to any one of the two platform carrying parts 1, while the other platform carrying part 1 does not have a corresponding connecting part 3. In the process from the unfolded state to the folded state, it is necessary to rotate the platform carrying part 1 which is connected to the connecting part 3 to enable the connecting part 3 to drive the support part 2 to move. Of course, there may be two connecting parts 3. It means that the two connecting parts 3 are correspondingly connected to the platform carrying parts 1, respectively, and the two connecting parts 3 located between the two adjacent platform carrying parts 1 are connected to the same support part 2 to improve the stability of the support part 2 when it moves.

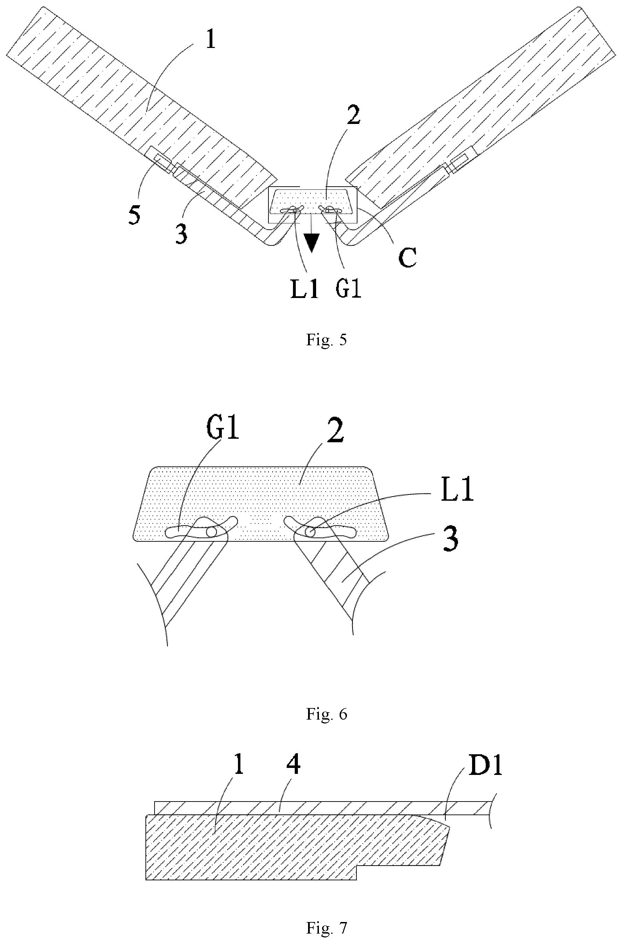

Referring to Fig. 4 and Fig. 5, in the process from the unfolded state to the folded state of the foldable support structural member, the two adjacent platform carrying parts 1 need to move relative to each other to drive the flexible display panel 4 to be folded and bent. In the folded state, the support part 2 can be pressed and connected onto the bending portion W of the flexible display panel 4. The pressing connection means that the support part 2 is in contact with the bending portion W of the flexible display panel 4 and exerts a certain pressure to the bending portion W. Under the pressure of the support part 2, the bending portion W of the flexible display panel 4 will be deformed, and the bending radius of the bending portion W of the flexible display panel 4 will correspondingly increase, so that the bending stress at the bending portion W of the flexible display panel 4 can be reduced, and the creases caused by being bent on the flexible display panel 4 can be alleviated.

In the above embodiments, in order to enable the support part 2 to be pressed and connected onto the bending portion W of the flexible display panel 4, the connecting part 3 needs to connect the support part 2 with one of the platform carrying parts 1. Since at least two platform carrying parts 1 are provided, a plurality of connecting parts 3 can be provided to respectively connect with the platform carrying parts. Of course, it is possible to provide one connecting part 3. When the platform carrying part 1 connected to the connecting part 3 moves, the connecting part 3 can be driven to move together, so as to further drive the support part 2 to be pressed and connected onto the bending portion W of the flexible display panel 4 through the connecting part 3.

The connecting part 3 is movably connected to at least one of the platform carrying part 1 and the support part 2, so that the connecting part 3 can move together with the platform carrying part 1 and drive the support part 2 to be pressed and connected onto the bending portion W of the flexible display panel 4. Optionally, the connecting part 3 is slidably connected to platform carrying part 1 to allow connecting part 3 to move relative to platform carrying part 1.

It can be understood that connecting part 3 is slidably connected to the platform carrying part 1, which means that the connecting part 3 can extend or retract relative to the platform carrying part 1. By retracting and extending of the connecting part 3 in the unfolded state and the folded state, the support part 2 can be driven to move, so as to adjust the position of the support part 2 and control the pressing connection effect of the support part 2 onto the bending portion W of flexible display panel 4. Specifically, since the change of bending radius of the bending portion W of the flexible display panel 4 is caused by the action of the support part 2, the degree of deformation at the bending portion W of the flexible display panel 4 caused by the support part 2, i.e. the degree of the change of the bending radius, can be adjusted by adjusting the relative position between the support part 2 and the bending portion W of the flexible display panel 4 in the folded state. Optionally, in the process of pressing support part 2 pressingly being connected onto flexible display panel 4, the movement distance of the support part 2 towards a direction close to flexible display panel 4 may be within 0mm to 3mm, such as 0.5mm, 1mm, 2mm or 3mm.

It should be noted that from the unfolded state to the folded state, the connecting part 3 can extend outwards a certain length relative to the platform carrying part 1. Since the other end of connecting part 3 is connected to support part 2, the connecting part 3 can drive the support part 2 to move away from flexible display panel 4 at a certain distance, that is, drive the support part 2 to move down at a certain distance, when extends outwards. The longer the movement distance of the support part 2 towards a direction close to the flexible display panel 4 is, the larger the acting force of the support part 2 onto the flexible display panel 4. The shorter the movement distance of the support part 2 towards the direction close to flexible display panel 4, the smaller the acting force of the support part 2 onto flexible display panel 4. By adjusting the distance of the support part 2 moving in a direction away from the flexible display panel 4, the damage to the flexible display panel 4 due to the excessive force exerted by the support part 2 on the bending point W of the flexible display panel 4 can be avoided, while the increasing degree of the bending radius of the bending portion W of the flexible display panel 4 can be ensured to meet the requirements.

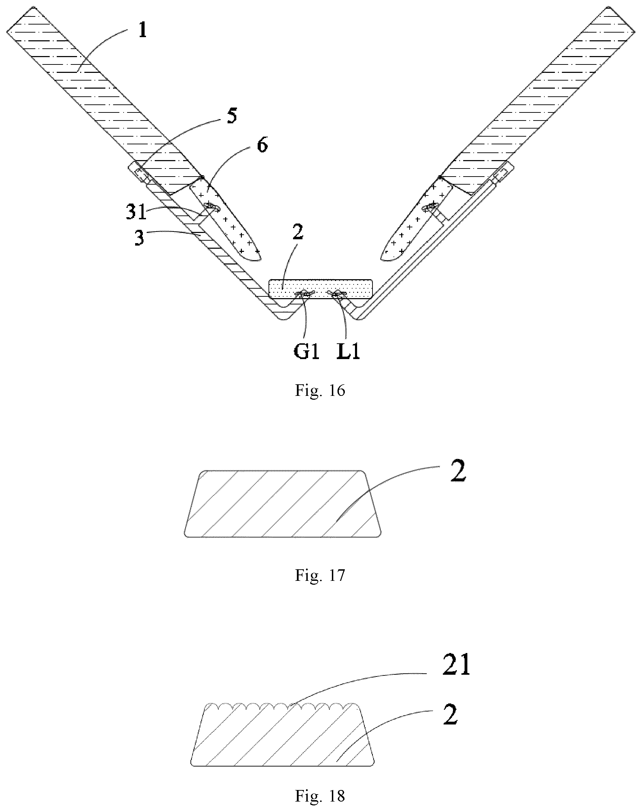

In addition to the above-mentioned method of adjusting the movement of the support part 2 towards the direction close to the flexible display panel 4, other methods can be used to adjust the acting force of the support part 2 onto the bending portion W of the flexible display panel 4, such as adjusting the size and shape of the support part 2. Specifically, as shown in Fig. 17 to Fig. 24, at least one convex part 21 is arranged on a side of the support part 2 facing the flexible display panel 4, and the shape of the convex part 21 includes at least one of flat plane, arc shape or serrated shape.

It can be understood that since the convex part 21 is further provided, the convex part 21 can be contact with the flexible display panel 4. Under the action of the convex part 21, the deformation of the bending portion W of the flexible display panel 4 will be more significant, that is, the bending radius of the bending portion W of the flexible display panel 4 will increase more, which can improve the improvement effect of the creases on the flexible display panel 4.

Optionally, the shape of the convex part 21 may be a flat plane, a wave shape, a curved face with a single arc-shaped face, a serrated surface formed by a plurality of folding surfaces or the like. The convex part 21 can cover a surface of on a side of the support part 2, or can merely be arranged in a partial region of a surface on a side of the support part 2, for example, can merely be arranged in the middle of a surface on a side of the support part 2 to reduce the production cost.

Referring to Fig. 2 to Fig. 5, In order to improve the stability of the sliding connection between the connecting part 3 and the platform carrying part 1 and achieve the hovering effect during the folding process, optionally, the connecting part 3 and the platform carrying part 1 can be connected through a damper 5. The damper 5 can act as a buffer for the relative movement between the connecting part 3 and the platform carrying part 1 in the transition process of the foldable support structural member from the unfolded state to the folded state, and can improve the structural stability of the foldable support structural member in the transition process from the unfolded state to the folded state. The damper 5 specifically includes one of a compression spring or a Z-shaped spring, which can achieve the buffering effect by the elastic deformation of the compression spring or the Z-shaped spring.

Referring to Fig. 1 and Fig. 7, after the flexible display panel 4 is compressed by the support part 2 in the folded state, the bending portion W may generate an irregular arc, which can affect the flatness of the flexible display panel 4. To solve the above problem, optionally, a first chamfer D1 is arranged at an end of the platform carrying part 1 close to the support part 2 and on a side of the platform carrying part 1 towards the flexible display panel 4.

It can be understood that due to arranging the first chamfer D1, a free space with a certain volume is formed between the platform carrying part 1 and the flexible display panel 4 to accommodate a bending and compression portion of the flexible display panel 4 in the folded state, so that a space for the stress release of the bending and compression portion of the flexible display panel 4 can be provided. Optionally, a buffer layer, such as silicone material, can be arranged between the first chamfer D1 of the platform carrying part 1 and the flexible display panel 4, so as to achieve the stress release at the bending portion W of the flexible display panel 4. A bending radius of the first chamfer D1 can be set according to the bending radius of the flexible display panel 4. Optionally, the bending radius of the first chamfer D1 may be within 10mm to 50mm.

As shown in Fig. 6, in order to further improve the accuracy and stability of adjusting the movement distance of the support part 2 towards the direction close to the flexible display panel 4, the support part 2 is provided with a first rail groove G1, and the connecting part 3 is slidably connected to the first rail groove G1.

In this embodiment, the connecting part 3 can move along the first rail groove G1 and the movement of the support part 2 can be confined by the relative position between connecting part 3 and the first rail groove G1.

Optionally, the connecting part 3 includes a first connecting portion L1 connected to the support part 2, and the first connecting portion L1 is movably connected to the support part 2.

It should be noted that the first connecting portion L1 is movably connected to the support part 2, and specifically, the first connecting portion L1 can be connected to the support part 2 in a rotatable connection, a slidable connection or other connection methods that can achieve the relative displacement between the first connecting portion L1 and the support part 2. It should be noted that since the rotatable connection between the first connecting portion L1 and the support part 2 cannot achieve the relative displacement between the two, in order to adjust the movement distance of the support part 2 towards the direction close to the flexible display panel 4, it is necessary to ensure that the connecting part 3 is slidably connected to the platform carrying part 1, so as to adjust the movement distance of the support part 2 towards the direction close to the flexible display panel 4 through the relative displacement between the connecting part 3 and the platform carrying part 1.

When the sliding connection or another connection method that can achieve the relative displacement between the first connecting portion L1 and the support part 2 is used for the connection between the first connecting portion L1 and the support part 2, the connecting part 3 may be sliably connected to the platform carrying part 1, or the connecting part 3 may be fixedly connected to the platform carrying part 1, and the connection method is not specifically confined.

It can be understood that the first connecting portion L1 of the connecting part 3 can move along the first rail groove G1. When the foldable support structural member is transitioned from the unfolded state to the folded state, the connecting part 3 drives the support part 2 to move together, and the first connecting portion L1 of the connecting part 3 can move along the first rail groove G1, and can move from an end of the first rail groove G1 close to the center of the support part 2 to an end of the first rail groove G1 away from the center of the support part 2. By restricting the specific trajectory of the first rail groove G1, when the first connecting portion L1 is located at the end of the first rail groove G1 close to the center of support part 2 or the first connecting portion L1 is located at the end of the first rail groove G1 away from the center of support part 2, a corresponding position of the support part 2 can be adjusted.

For example, in the unfolded state, the first connecting portion L1 is located at the end of the first rail groove G1 close to the center of the support part 2, and the position of the support part 2 is a first position; in the folded state, the first connecting portion L1 is located at the end of the first rail groove G1 away from the center of the support part 2, the position of the support part 2 is a second position. The second position is at a certain distance in the direction away from the flexible display panel 4 from the first position.

Optionally, the first connecting portion L1 may be a rotatable shaft that can be rotatably connected to other parts of the connecting part 3, so that the first connecting portion L1 can rotate relative to the support part 2 while moves along the first rail groove G1. Therefore, the friction between the first connecting portion L1 and the support part 2 can be reduced, and the movement smoothness of the first connecting portion L1 can be improved.

Optionally, the first rail groove G1 extends from the center of the support part 2 to a side of the support part 2 close to the connecting part 3, so as to meet the requirement of the relative position change between the connecting part 3 and the support part 2 in the transition process of the foldable support structural member from the unfolded state to the folded state. In addition, in order to improve the smoothness of connecting part 3 sliding along the first rail groove G1 during the transition process of the foldable support structural member from the unfolded state to the folded state, an extending path of the first rail groove G1 is a curve, and the specific trajectory of the curve can be adjusted according to the actual needs. In other embodiments of the present application, the extending path of the first rail groove G1 may be a straight line or a folding line, which is not confined by the present application.

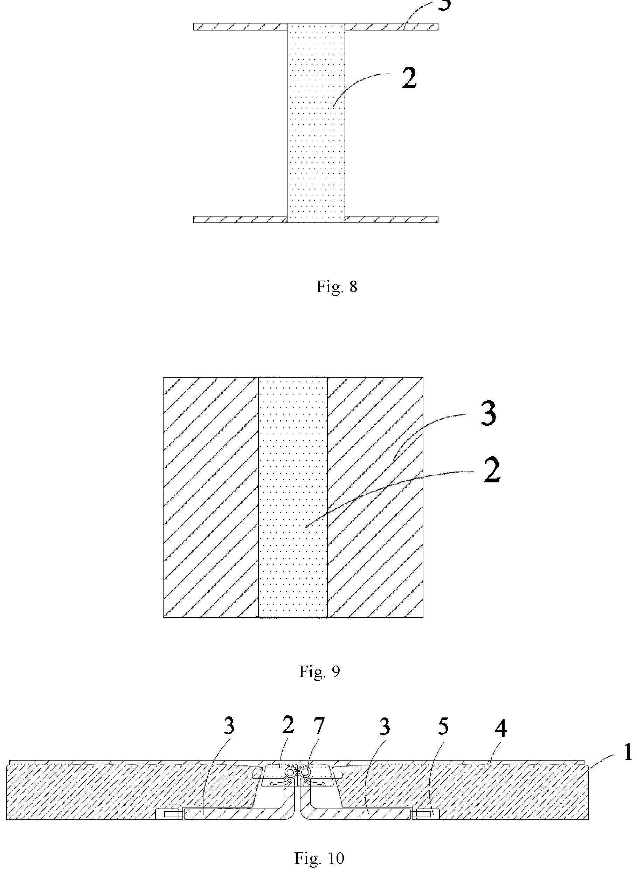

Referring to Fig. 8, in order to further improve the structural stability among the connecting part 3, the platform carrying part 1 and the support part 2, in some optional embodiments, the connecting part 3 includes at least two connecting rods, which are connected to the platform carrying part 1 and support part 2, respectively. The at least two connecting rods are spaced apart from one another in a length direction of the support part 2.

It can be understood that the more the connecting rods included in connecting part 3 are, the more the connecting rods connected to the single platform carrying part 1 are, and the better the stability of the structure is. However, more connecting rods require a bigger arrangement space and a more complex process. In this embodiment, specifically, the support part 2 is in a strip-shaped structure. Since the connecting rods merely need to drive the support part 2 to move, optionally, the connecting part 3 includes two connecting rods, which are connected to two ends of the platform carrying part 1 in the length direction, respectively. The arrangement of the above connecting rods is convenient for production on one hand, and can also improve the uniformity of the force on the platform carrying part 1 on the other hand.

Of course, in order to ensure the movement stability of the support part 2, the connecting part 3 can also be in a strip-shaped structure corresponding to the support part 2. Referring to Fig. 9, specifically, the connecting part 3 includes a connecting plate, which is connected to the platform carrying part 1 and the support part 2, and extends in the length direction of the support part 2.

It can be understood that since the connecting part 3 includes the single connecting plate, the connecting plate can be connected to the support part 2 in the length direction of the support part 2, thereby improving the stability of the connection between the connecting plate and support part 2. Specifically, an extending length of the connecting part 3 is equal to an extending length of the support part 2, so as to facilitate the corresponding connection between the connecting part 3 and the support part 2.

Optionally, a cross section of the connecting part 3, which is perpendicular to the length direction of the support part 2, is in an L shape. Specifically, each of a cross-section of the connecting rod and a cross-section of the connecting plate perpendicular to in the length direction of the support part 2 can be an L shape. It can be understood that the connecting part 3 with the L-shaped cross-section has a long end and a short end. Generally, the long end of the connecting part 3 is connected to the platform carrying part 1, and the short end of the connecting part 3 is connected to the support part 2, so as to allow the connecting part 3 to adapt to the relative positions of the platform carrying part 1 and the support part 2.

In view of the difficulty of the manufacturing process and the practical requirements, the foldable support structural member includes two platform carrying parts 1 and two connecting parts 3. Each of the platform carrying parts 1 is connected to the support part 2 through one of the connecting parts 3, the two platform carrying parts 1 are symmetrically arranged relative to the support part 2, and the two connecting parts 3 are symmetrically arranged relative to the support part 2.

It can be understood that the connecting parts 3, which are connected to different platform carrying parts 1 respectively, need to be connected to the same support part 2. Therefore, the connecting parts 3 are symmetrically arranged relative to the support part 2 to improve the force symmetry of support part 2 and the stabilities of support part 2 and connecting parts 3 during the transition between the unfold state and the folded state.

Optionally, an accommodating groove is provided on a side of the platform carrying part 1 away from the flexible display panel 4 to accommodate the connecting part 3. At least a portion of the long end of the connecting part 3 is arranged in the accommodating groove, so as to facilitate arranging the connecting part 3 and reduce the overall thickness of the foldable support structural member.

Referring to Fig. 1 and Fig. 10, in order to ensure the stability of the relative rotation between two adjacent platform carrying parts 1, optionally, the relative rotation connection between the two adjacent platform carrying parts 1 can be achieved through a rotating part 7, which can be a gear, a hinge or the like. In order to avoid the influence of the gear assembly or the hinge on the arrangement of the connecting parts 3 and the support parts 2, the rotating assemblies such as the gear assemblies or the hinges can be arranged on two sides of the platform carrying part 1, that is, two ends of the platform carrying part 1 in the length direction.

In view of the flexible display panel 4 being in a U-shaped structure in the folded state, which is relatively simple, the stable carrying performance of the flexible display panel 4 can be achieved by adopting the platform carrying part 1 and support part 2 as described above. However, if the flexible display panel 4 is desired to be in a droplet-shaped structure in the folded state to reduce the folding thickness of the flexible display panel 4, other parts can also be arranged to define a bending shape of the flexible display panel 4.

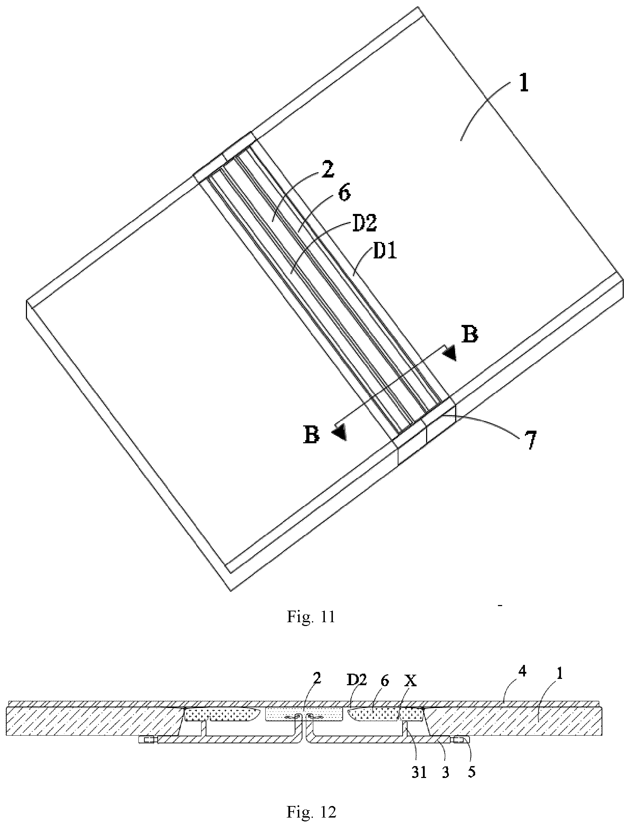

Referring to Fig. 11 to Fig. 13, in some optional embodiments, the foldable support structural member further includes an auxiliary support part 6. The auxiliary support part 6 is arranged between the support part 2 and the platform carrying part 1, the auxiliary support part 5 is rotatably connected to one of the support part 2 and the platform carrying part 1, and the connecting part 3 is provided with a confining part 31 matching with the auxiliary support part 6. In the unfolded state, the confining part 31 is configured to support the auxiliary support part 6, and the auxiliary support part 6, the platform carrying part 1 and the support part 2 jointly support the flexible display panel 4; in the folded state, the confining part 31 is configured to confine movement of the auxiliary support part 6, and the auxiliary support part 6 abuts against the flexible display panel 4 and defines the bending shape of the flexible display panel 4.

It should be noted that in order to make the flexible display panel 4 form in the droplet-shaped structure in the folded state, the auxiliary support part 6 needs to abut against side faces of the flexible display panel 4 opposite to each other, so that a portion of the flexible display panel 4 is concave towards the center to define the bending shape of the flexible display panel 4. Of course, the auxiliary support part 6 also needs to cooperate with the support part 2 to jointly define the overall bending shape of the flexible display panel 4.

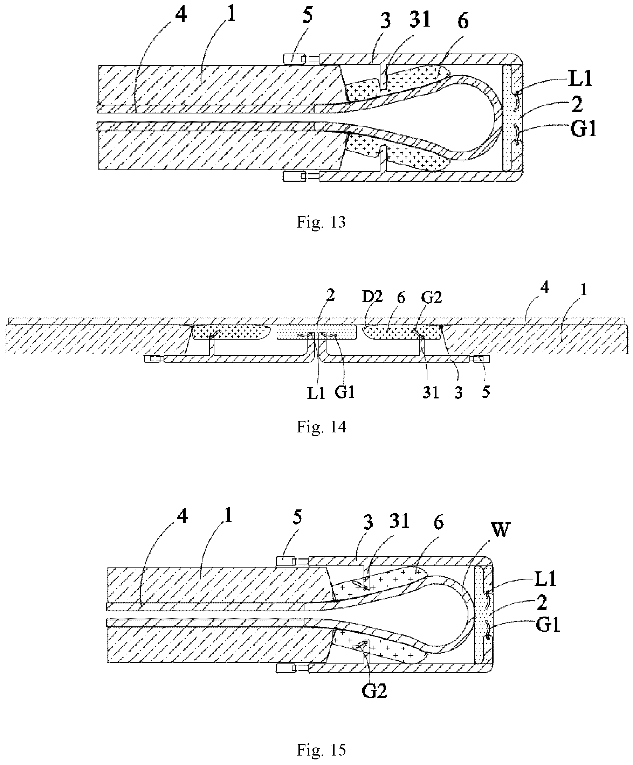

Since the auxiliary support part 6 abuts against the opposite side faces of the flexible display panel 4, the flexible display panel 4 can be bent and deformed. Therefore, the irregular arc can be formed in the portion where the flexible display panel 4 is bent and deformed. As shown in Fig. 14, optionally, a second chamfer D2 can be arranged at an end of the auxiliary support part 6 close to the support part 2 and on a side of the auxiliary support part 6 towards the flexible display panel 4. By arranging the second chamfer D2, a free space with a certain volume is formed between the auxiliary support part 6 and the flexible display panel 4 to accommodate the bending and compression portion of the flexible display panel 4 in the folded state, so that a space for the stress release of the bending and compression portion of the flexible display panel 4 can be provided. Optionally, the bending radius of the second chamfer D2 is within 10mm to 50mm.

Optionally, the end of the auxiliary support part 6 close to the support part 2 is in an arc shape. Since the end of the auxiliary support part 6 close to the support part 2 abuts against the flexible display panel 4 in the folded state, by setting the end of the auxiliary support part 6 close to the support part 2 to be in the arc shape, the damage to the flexible display panel 4 caused by the auxiliary support part 6 in the folded state can be avoided and the service life can be improved.

It can be understood that in the unfolded state, the surfaces of the auxiliary support part 6, the platform carrying part 1 and the support part 2 facing the flexible display panel 4 can be located in the same plane to achieve the flat support for the flexible display panel 4. In view of the rotatable connection between the auxiliary support part 6 and one of the support part 2 and the platform support part 1, in the process from the unfolded state to the folded state, the rotation of the platform carrying part 1 and/or the support part 2 can drive the rotation of the auxiliary support part 6. In order to improve the stability of the auxiliary support part 6 in the unfolded state or the folded state, the confining part 31 is arranged on the connecting part 3. The confining part 31 needs to support the auxiliary support part 6 in the unfolded state, so that the auxiliary support part 6 can be smoothly contact with the flexible display panel 4 and support the flexible display panel 4. In the folded state, the confining part 31 can be used to confine the movement of the auxiliary support part 6, so as to maintain the desired bending shape of the flexible display panel 4.

Specifically, the confining part 31 may be a convex block or other structures that can cooperate with the auxiliary support part 6, as long as can confine the movement of the auxiliary support part 6, so that the auxiliary support part 6 can maintain a relatively stable state in both the unfolded state and the folded state.

Referring to Fig. 12 and Fig. 13, optionally, the auxiliary support part 6 is provided with a confining groove X matching with the connecting part 3; in the folded state, the confining part 31 extends into the confining groove X to fix the auxiliary support part 6. It can be understood that in the process from the unfolded state to the folded state, the connecting part 3 and the auxiliary support part 6 move relative to each other. By adjusting the arrangement positions of the confining part 31 and the confining groove X, the lower confining part 31 can precisely extend into the confining groove X in the folded state. Therefore, the fixing of the auxiliary support part 6 can be achieved through the mutual restriction between the confining part 31 and the confining groove X.

Of course, in addition to the structural form that the confining part 31 matches with the confining groove X, other structural forms can be used to restrict the auxiliary support part 6. Referring to Fig. 14 to Fig.16, optionally, the auxiliary support part 6 is provided with a second rail groove G2, and the confining part 31 is slidably connected to the second rail groove G2. It can be understood that in the unfolded state, the confining part 31 is located at an end of the second rail groove G2. When the unfolded state transitions to the folded state, the confining part 31 moves from the end of the second rail groove G2 to the other end of the second rail groove G2. The movement trajectory of the confining part 31 can be restricted through the second rail groove G2, so that the auxiliary support part 6 can maintain the relatively stable state in both the unfolded state and the folded state.

A specific shape and an extending trajectory of the second rail groove G2 can be selected based on the relative position between the connecting part 3 and the auxiliary support part 6, as long as can ensure the stability of the auxiliary support part 6 in the unfolded state and the folded states.

Optionally, the second rail groove G2 extends from a side of the auxiliary support part 6 close to the connecting part 3 towards a direction away from the connecting part 3, so as to meet the requirement of the relative position change between the connecting part 3 and the auxiliary support part 6 in the transition process of the foldable support structural member from the unfolded state to the folded state.

The embodiments of the present application further provide a display device including the flexible display panel 4 and the foldable support structural member according to the embodiments as described above. The foldable support structural member is arranged on a backlight side of the flexible display panel 4.

In the embodiments of the present application, the foldable support structural member is arranged on the backlight side of the flexible display panel 4, so as to support and fix the flexible display panel 4 and ensure the flatness of the flexible display panel 4 during using. In other words, the platform carrying parts 1 and support part 2 of the foldable support structural member can carry the flexible display panel 4 in both the unfolded state and the folded state. In the process from the unfolded state to the folded state, two adjacent platform carrying parts 1 move relative to each other to be arranged opposite to each other, so as to drive the flexible display panel 4 to be bent accordingly. In the embodiments of the present application, by moving the connecting part 3 with the platform carrying parts 1 and driving the support part 2 to be pressed and connected onto the bending portion W of the flexible display panel 4, that is, by exerting the pressure onto the bending portion W of the flexible display panel 4 through the support part 2, the bending portion W of the flexible display panel 4 is bent and deformed in a direction away from the support part 2, thereby increasing a bending radius of the bending portion W of the flexible display panel 4. Due to the relatively large bending radius, the time of forming the cracks and the bending marks caused by the bending portion W of the flexible display panel 4 being bent for a long term can be delay, the creases caused by the flexible display panel 4 being bent can be reduced, the service life of the flexible display panel 4 can increase, the using stability of the flexible display panel 4 can be improved, and the display effect and the user visual experience of the flexible display panel 4 can be improved.

In the related art, the bending radius of the bending portion W of the flexible display panel 4 is usually less than 2mm. In the embodiments of the present application, by driving the support part 2 to be pressed and connected onto the bending portion W of the flexible display panel 4, the bending radius of the bending portion W of the flexible display panel 4 can increase. Optionally, in this embodiment, in the folded state of the flexible display panel 4, the bending radius of the bending portion W of the flexible display panel 4 may be within 2mm to 3mm, which is significantly increased compared with the bending radius of the bending portion W of the flexible display panel 4 in the related art, thereby effectively reducing the creases caused by being bent on the flexible display panel 4.

The display device provided by the embodiments of the present application has the technical effect of the foldable support structural member according to any one of the above embodiments. The explanations of the structures and terms same as or corresponding to those in the above embodiments will not be repeated here.

The display device provided by the embodiments of the present application can be applied to a mobile phone or any other electronic product with the display function, including but not confined to the following categories: a television, a laptop, a desktop display device, a tablet computer, a digital camera, a smart bracelet, a smart glasses, a car mounted display device, a medical device, an industrial control device, a touch interaction terminal and the like, which are not specially confined by the embodiments of the present application.

The embodiments of the present application are described above. Those skilled in the art can clearly understand that, for the convenience and conciseness of the description, the specific working processes of the system, module and unit described above can refer to the corresponding processes in the aforementioned method embodiments, which will not be repeated here. It should be understood that the scope of the present application is not confined to these. Any skilled in the art who is familiar with the technical field can easily think of various equivalent modifications or replacements within the scope disclosed in the present application. These equivalent modifications or replacements should be covered within the scope of the present application.

## Claims

1. A foldable support structural member for supporting a flexible display panel, comprising an unfolded state and a folded state, and comprising
at least two platform carrying parts, a support part and a connecting part, two adjacent platform carrying parts being movably connected with each other through the support part and the connecting part, the connecting part connecting the support part with one of the platform carrying parts, and the connecting part being movably connected to at least one of the platform carrying part and the support part;
in a process from the unfolded state to the folded state, the two adjacent platform carrying parts moving relative to each other, and the connecting part moving with the platform carrying parts and driving the support part to be pressed and connected onto a bending portion of the flexible display panel.

2. The foldable support structural member according to claim 1, wherein in a process of pressing and connecting the support part onto the flexible display panel, a movement distance of the support part in a direction towards the flexible display panel is 0 mm to 3 mm.

3. The foldable support structural member according to claim 1, wherein the support part is provided with a first rail groove, and the connecting part is slidably connected to the first rail groove.

4. The foldable support structural member according to claim 3, wherein the first rail groove extends from a center of the support part towards a side close to the connecting part, and an extending path of the first rail groove is in a curve.

5. The foldable support structural member according to claim 1, further comprising an auxiliary support part, wherein the auxiliary support part is arranged between the support part and the platform carrying part, the auxiliary support part is rotatably connected to one of the support part and the platform carrying part, and the connecting part is provided with a confining part matching with the auxiliary support part;
in the unfolded state, the confining part is configured to support the auxiliary support part, and the auxiliary support part, the platform carrying part, and the support part j ointly support the flexible display panel; in the folded state, the confining part is configured to confine movement of the auxiliary support part, and the auxiliary support part abuts against the flexible display panel and defines a bending shape of the flexible display panel.

6. The foldable support structural member according to claim 1, wherein a first chamfer is arranged at an end of the platform carrying part close to the support part and on a side of the platform carrying part towards the flexible display panel.

7. The foldable support structural member according to claim 5, wherein a second chamfer is arranged at an end of the auxiliary support part close to the support part and on a side of the auxiliary support part towards the flexible display panel, and the end of the auxiliary support part close to the support part is in an arc shape.

8. The foldable support structural member according to claim 5, wherein the auxiliary support part is provided with a confining groove matching with the connecting part; in the folded state, the confining part extends into the confining groove to fix the auxiliary support part, and in the unfolded state, the confining part extends out of the confining groove.

9. The foldable support structural member according to claim 5, wherein the auxiliary support part is provided with a second rail groove, the confining part is slidably connected to the second rail groove, and the second rail groove extends from a side of the auxiliary support part close to the connecting part towards a direction away from the connecting part.

10. The foldable support structural member according to claim 1, wherein the connecting part comprises at least two connecting rods, which are connected to the platform carrying part and the support part, respectively, and the at least two connecting rods are spaced from one another in a length direction of the support part; or, the connecting part comprises a connecting plate, which is connected to the platform carrying part and the support part, and the connecting plate extends in a length direction of the support part.

11. The foldable support structural member according to claim 10, wherein a cross section of the connecting part, which is perpendicular to the length direction of the support part, is in an L shape.

12. The foldable support structural member according to claim 10, further comprising two platform carrying parts and two connecting parts, each of the platform carrying parts is connected to the support part through one of the connecting parts, the two platform carrying parts are symmetrically arranged relative to the support part, and the two connecting parts are symmetrically arranged relative to the support part.

13. The foldable support structural member according to claim 10, wherein an accommodating groove is provided on a side of the platform carrying part away from the flexible display panel to accommodate the connecting part.

14. The foldable support structural member according to claim 1, wherein at least one convex part is arranged on a side of the support part facing the flexible display panel.

15. The foldable support structural member according to claim 14, wherein a shape of the convex part comprises at least one of flat plane, arc shape or serrated shape.

16. The foldable support structural member according to claim 1, wherein the connecting part is slidably connected to the platform carrying part to enable the connecting part to move relative to the platform carrying part.

17. The foldable support structural member according to claim 16, wherein the connecting part and the platform carrying part are connected through a damper.

18. The foldable support structural member according to claim 17, wherein the damper comprises one of a compression spring or a Z-shaped spring.

19. A display device comprising:
a flexible display panel;
the foldable support structural member according to any one of claims 1 to 18, arranged on a backlight side of the flexible display panel.

20. The display device according to claim 19, wherein in the folded state, a bending radius at the bending portion of the flexible display panel is 2mm to 3mm.
